# EUROPÄISCHE PATENTSCHRIFT

(11) **EP 1 700 348 B1**
(45) Veröffentlichungstag und Bekanntmachung des Hinweises auf die Patenterteilung: **28.03.2007**
(21) Anmeldenummer: 04820947.2
(22) Anmeldetag: 26.11.2004
(51) Int. Cl.: H01L 31/048, H01L 31/042, H01L 31/02

(54) **PHOTOVOLTAIK-ISOLIERGLASSCHEIBE**
PHOTOVOLTAIC INSULATING WINDOW PANE
VITRE D'ISOLATION POUR MODULES PHOTOVOLTAIQUES

(30) Priorität: 24.12.2003 DE 10361184
(43) Veröffentlichungstag der Anmeldung: 13.09.2006
(73) Patentinhaber: GLASWERKE ARNOLD GmbH & Co. KG, 91732 Merkendorf (DE)
(72) Erfinder: SCHMIDT, Christoph, 91710 Gunzenhausen (DE)
(74) Vertreter: Langöhrig, Angelika Beate
(86) Internationale Anmeldenummer: PCT/EP2004/013409
(87) Internationale Veröffentlichungsnummer: WO 2005/067060

(56) Entgegenhaltungen:
- EP-A- 0 917 211
- EP-A- 1 120 837
- WO-A-03/028114
- DE-A1- 3 129 553
- DE-A1- 10 055 617
- DE-U1- 29 605 510
- US-A1- 2003 193 322

## Beschreibung

Die Erfindung betrifft eine Photovoltaik-Isolierglasscheibe umfassend eine dem einfallenden Licht zugewandte Außenscheibe und eine hierzu beabstandete und mit der Außenscheibe einen Scheibeninnenraum einschließende Innenscheibe, wobei im Randbereich der Scheiben zwischen diesen ein aus einem Hohlprofil gebildeter Abstandshalterrahmen vorgesehen ist und wobei im Scheibeninnenraum dem einfallenden Licht zugewandt ein oder mehrere Photovoltaikmodule angeordnet und Bypassdioden zwischen die Photovoltaikmodule geschaltet sind.

Generell ist es bei Isolierglasscheiben, die Photovoltaikmodule enthalten, z. B. auf Basis kristalliner Solarzellen, aber auch unter Umständen bei Dünnschicht-Solarmodulen notwendig, sogenannte "Bypassdioden" vorzusehen bzw. einzelne Teile des Solargenerators, sogenannte "Strings", über Bypassdioden zueinander parallel zu schalten. Hierzu müssen die Anschlusskabel, in der Regel Flachleiter oder sogenannte "Kontaktbändchen", aus dem Solarmodul austreten, wobei dies entweder im Scheibenzwischenraum oder außerhalb des Scheibenzwischenraums erfolgen kann. Dabei ist es wichtig, dass die weitere Verbindung der sogenannten Kontaktbändchen unter bestimmten Voraussetzungen insbesondere zugentlastet erfolgt.

Eine derartige photovoltaische Isolierglasscheibe ist beispielsweise aus der DE 100 55 617 bekannt, die eine Isolierglasscheibe zum Einbau in Fassadenverglasungen, Fenstern, Wintergärten, Glashäusern oder ähnliches beschreibt, und mit der auf photovoltaischem Weg Strom erzeugt werden kann. Die Scheibe soll dabei eine Vorderscheibe und eine von dieser beabstandete Hinterscheibe aufweisen. Durch einen zwischen den Scheiben an deren äußeren Rändern etwas nach innen versetzt umlaufend angeordneten Abstandshalter wird ein geschlossener Scheibenzwischenraum gebildet, in welchem die Solarzellen angeordnet sind. Außen- und Innenscheibe sollen dabei mit einer dauerelastischen Dichtmasse mit dem Abstandshalter verklebt werden. Dabei soll vorgesehen sein, dass der umlaufende Abstandshalter auf einige Zentimeter unterbrochen ist, und in dieser Unterbrechung ein angepasstes Anschlusselement angeordnet ist, in welchem die Anschlusskabel zugentlastet verlegt sowie eine Bypassdiode untergebracht ist. Nachteilig ist bei einer solchen Gestaltung, dass ein Sonderbauteil vorgesehen werden muss und die Montage bei der Herstellung der photovoltaischen Isolierglasscheibe verhältnismäßig aufwendig ist und nur ein geringer Grad an Vorfertigung erfolgen kann.

Darüber hinaus ist beispielsweise aus der DE 296 05 510 ein plattenförmiges Solarmodul bekannt, bei dem die mit den Solarzellen elektrisch verschalteten Anschlusskabel in einer außerhalb des Plattenaufbaus auf dessen Rand angeordneten Isolierhülse geführt werden. Die Isolierhülse ist an ihren Enden als Buchse bzw. Stecker ausgebildet und kann so mit benachbarten Solarmodulen verschaltet werden. Außerdem nimmt die Isolierhülse eine zu den Anschlusskabeln parallel geschaltete Bypassdiode auf.

Auch hierbei ist nachteilig, dass ein zusätzliches Bauteil, nämlich eine Dichthülse vorgesehen werden muss, die später bei der Endmontage der Isolierglasscheibe mit durch den Rahmen und Dichtmasse umgeben werden muss, so dass aufgrund der benötigten größeren Abmessungen am Rand mehr Dichtstoff aufgebracht werden muss, damit die Hülse eingeschlossen ist. Darüber hinaus bestehen Probleme in der Wärmeabfuhr der in den Bypassdioden entstehenden Wärme.

Weiterhin ist es bekannt, die Bypassdioden außen auf das Hohlprofil aufzubringen, und danach zusammen mit dem Hohlprofil in den Dichtstoff einzubetten. Dabei ist es generell vorgesehen, dass das Hohlprofil, das zur Beabstandung der beiden Scheiben zueinander dient, zusammen mit den Scheibenkanten in Dichtstoff eingeschlossen wird, um so einen gas- und dampfdichten Abschluss des Scheibenzwischenraumes zu erreichen. Die Dichtstoffüberdeckung beträgt dabei in der Regel bei normalen Isolierglasscheiben ca. 2 bis 3 mm. Sofern noch eine Bypassdiode mit eingebettet werden muss, muss ebenso wie bei der Isolierhülse die Dichtstoffüberdeckung erheblich größer gewählt werden, so dass bei gleichbleibender Scheibenfläche die Abstandshalterprofile um ein größeres Maß vom Scheibenrand zu Scheibenmitte hin angeordnet werden müssen.

Schließlich kann eine Festlegung der Kontaktbändchen der DE 101 46 498 A1 entnommen werden, die eine Herausführung und Kontaktierung der Kontaktbändchen aus der Isolierglasscheibe in einer Art zeigt, wie sie auch bei der vorliegenden Erfindung Anwendung finden soll.

Dabei muss der Einbau der Bypassdioden in das Photovoltaik-Isolierglas folgende Anforderungen erfüllen:
- das Isolierglas muss gas- und wasserdampfdicht sein,
- die Wärmeabfuhr der Dioden muss ohne deren Erhitzung möglich sein,
- eine elektrische Isolationsfestigkeit muss gewährleistet sein,
- Dioden und Anschlüsse sollten von außen unsichtbar sein,
- der Montageablauf muss sich in die Isolierglasfertigung integrieren lassen,
- der Isolierglasrand sollte Standardabmessungen aufweisen,
- hoher Vorfertigungsgrad,
- keine oder wenige Sonderbauteile.

Die vorliegende Erfindung stellt sich daher nun die Aufgabe, eine Photovoltaik-Isolierglasscheibe bereitzustellen, mit der sich die Bypassdioden gut in den Standardaufbau einer Photovältaik-Isolierglasscheibe integrieren lassen, und bereits eine gute Vorfertigung bei gleichzeitig einfacher Endmontage möglich ist.

Die Erfindung löst diese Aufgabe durch eine Photovoltaik-Isolierglasscheibe der gattungsgemäßen Art wie in Anspruch 1 offenbart, bei der die Bypassdioden in dem Abstandshalterrahmen angeordnet sind und die elektrischen Anschlusskabel der Photovoltaikmodule am Abstandshalterrahmen festgelegt sind.

Durch den Einbau der Bypassdioden in das Abstandshalterhohlprofil entstehen eine Reihe von Vorteilen gegenüber den bisher bekannten Konstruktionen. Zum einen kann der Isolierglasrand Standardabmessungen insbesondere hinsichtlich der Dichtstoffabdeckung aufweisen, wobei dennoch ein hoher Vorfertigungsgrad möglich ist. D. h., die Dioden können bereits im Vorfeld in den Abstandshalter eingebracht werden, wobei es hierbei von Vorteil ist, wenn der Abstandshalter aus mehreren separaten Abschnitten zusammengesetzt ist, wobei jeder Abschnitt z. B. eine Diode aufweist. Auf diese Weise kann besonders einfach ein Einziehen der Diode in den Abstandshalter, aber auch eine Kontaktierung der einzelnen Solarmodule mit den Bypassdioden erfolgen, wobei die Bypassdioden zu den einzelnen Solarmodul-Strings parallel geschaltet werden. Darüber hinaus kann im Gegensatz zu Lösungen, bei denen die Bypassdioden in den Isolierglasdichtstoff eingebettet sind, bereits im Vorfeld eine Prüfung der Verschaltung erfolgen, ohne dass ein größerer Aufwand zum Auseinanderbauen der Isolierglasscheiben im Falle einer Fehlverschaltung bzw. einer Fehlfunktion der Dioden notwendig wird.

Sofern es sich bei dem Abstandshalter um einen elektrisch leitenden Abstandshalter, z. B. aus einem Metall handelt, muss eine entsprechende elektrische Isolierung vorgenommen werden.

Dabei kann vorgesehen sein, dass die Dioden in dem Abstandshalterprofil in Reihe geschaltet sind, wobei dann im Abstandshalter beispielsweise entsprechende Bohrungen vorgesehen sein können, um eine Kontaktierung der Reihenschaltung der Dioden mit den elektrischen Anschlusskabeln der einzelnen Solarmodule vorzunehmen, wobei eine Kontaktierung entsprechend der in der DE 101 46 498 A1 beschriebenen Form erfolgen kann.

Sofern das Abstandshalterprofil aus mehreren Bauteilen besteht, kann die Kontaktierung der Bypassdioden mit den Solarmodulen wahlweise im Bereich der Hohlprofile selbst bzw. im Bereich der Verbindungselemente erfolgen. Als Verbindungselemente können dabei sowohl Linear- als auch Eckverbinder vorgesehen sein.

Dabei können im Bereich der Verbinder sowohl Klemmverbindungen zwischen den elektrischen Bauteilen als auch Lötverbindungen vorgesehen werden.

Auf diese Weise kann ganz auf Sonderbauteile verzichtet werden. Die Dioden können dabei zuvor im Rahmen einer Vorfertigung in die Abstandshalterprofile eingeführt werden, so dass Fehleinbauten weitgehend vermieden werden können, ebenso wie Fehlverschaltungen. Die Montage in der Isolierglasproduktionslinie wird dann deutlich vereinfacht und es müssen lediglich wenige Handgriffe zur Kontaktierung vorgenommen werden.

Bei einer weiteren Ausgestaltung der Erfindung kann vorgesehen sein, dass spezielle Linearverbinder verwendet werden, in die die Bypassdioden integriert sind. Dies kann beispielsweise durch Eingießen von Bypassdioden in die Linearverbinder erfolgen und in diesem Fall kann die Kontaktierung mit den Solarmodulen neben einer Löt- oder Quetschverbindung auch über eine einfache Steckverbindung der Diodenanschlüsse erfolgen.

Sofern die Dioden im Abstandshalterprofil angeordnet sind, kann die Wärmeabfuhr über dasselbe erfolgen. Insbesondere sofern das Abstandshalterprofil ein Metallelement aufweist, erfolgt eine gute Wärmeableitung. Zur weiteren Wärmeableitung können im Abstandshalterprofil Kühlrippen angebracht sein. Um eine Isolation bei der Verwendung von Metallprofilen mit Metallschiene oder -auskleidung sicherzustellen, können als Isolationsmaterial beispielsweise Kunststofffolien verwendet werden, die in Form von Schläuchen auf die zu isolierenden Bauteile aufgeschrumpft werden können.

Schließlich kann vorgesehen sein, dass als Abstandshalterrahmen ein Kunststoffprofil verwendet wird, in welches eine Stromschiene eingelegt ist. Eine derartige Stromschiene kann als mitlaufende Metallfolie ausgebildet sein, so dass in diesen Fällen bei Verwendung eines speziellen Abstandshalterprofils die elektrische Leitung unmittelbar über das Abstandshalterprofil erfolgen kann. Es kann so besonders einfach eine elektrische Verbindung und Kontaktierung mit den Solarmodulen erfolgen.

Um eine sichere elektrische Isolierung zu erreichen, kann vorgesehen sein, dass zusätzlich zum Dichtstoff zum Abdichten der Isolierglasscheibe ein elektrisches Isoliermaterial vorgesehen ist, das zwischen Abstandhalterprofil und Dichtmasse angeordnet ist.

Schließlich kann vorgesehen sein, dass an den Kanten einer Isolierglasscheibe jeweils elektrische Anschlusselemente vorgesehen sind, mit denen das Photovoltaikmodul an ein externes Stromnetz angeschlossen werden kann. Diese können als einfache Buchsen-/Steckerverbindungen ebenfalls in den Abstandshalter integriert sein. Die dann erforderlichen Verbindungskabel werden erst bei der Scheibenmontage in die entsprechenden Stecker bzw. Buchsen eingesteckt.

Weitere Vorteile und Merkmale der Erfindung ergeben sich aus den übrigen Anmeldungsunterlagen. Die Erfindung soll im Folgenden anhand einer Zeichnung näher erläutert werden. Dabei zeigen:
- Figur 1: eine schematische Darstellung eines Photovoltaikmoduls;
- Figur 2: zwei Schnitte durch PV-Isolierglasscheiben;
- Figur 3: die Montage eines elektrischen Anschlusses nach einer ersten Ausgestaltung;
- Figur 4: eine zweite Ausgestaltung der Montage eines elektrischen Anschlusses;
- Figur 5: eine PV-Isolierglasscheibe in schematischer Darstellung und
- Figur 6: einen Schnitt durch eine PV-Isolierverglasung in schematischer Darstellung nach einer weiteren Ausgestaltung.

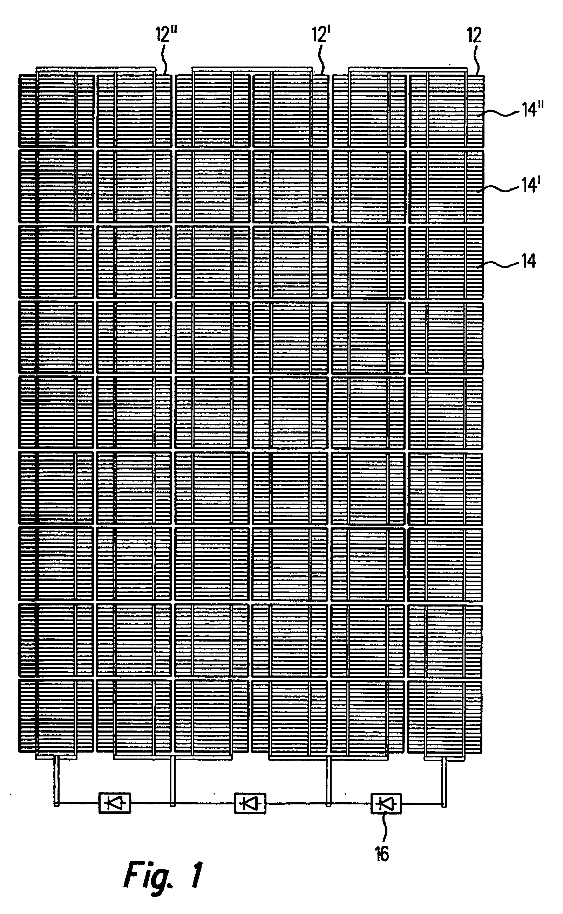

Dabei zeigt Figur 1 ein erfindungsgemäßes Photovoltaikmodul bestehend aus verschiedenen sogenannten Strings 12, 12' und 12", die aus in Reihe hintereinander geschalteten Solarzellen 14 und 14', 14", etc. gebildet sind. Die einzelnen Strings 12 sind mit Bypassdioden 16 verschaltet, wobei eine Bypassdiode 16 parallel zu einem zugeordneten String geschaltet ist. Dabei werden in einem Photovoltaik-Isolierglasscheibenelement jeweils eine Mehrzahl von z. B. 18 in einem Strang (String) geschalteten Solarzellen 14 vorgesehen. Die Vorsehung der Bypassdioden 16 erfolgt, um bei Ausfall einzelner Solarzellen 14 eine Überbrückung des Strings sicherzustellen und damit ein Aufheizen und Zerstören der Solarzellen zu verhindern. Die Bypassdioden 16 befinden sich dabei im normalen Betrieb im Sperrzustand und öffnen erst ab einer gewissen Durchbruchspannung.

Um eine gute Verbindbarkeit der einzelnen Strings 12 zu gewährleisten, werden die Stränge dabei vorzugsweise U-förmig in der Glasscheibe angeordnet, wie Figur 1 entnommen werden kann. In Figur 1 sind dementsprechend drei U-förmig angeordnete Strings 12, 12' und 12" dargestellt. Auf diese Weise können die elektrischen Anschlüsse der Strings vorteilhaft und mit kurzen Abständen zueinander vorgesehen sein.

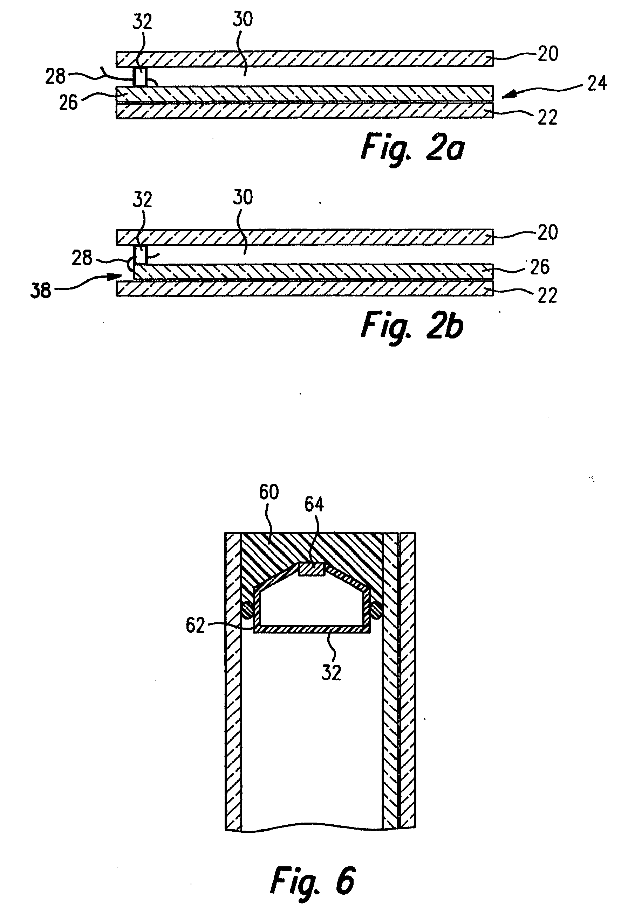

Figur 2 zeigt in Darstellung a) eine Isolierverglasung mit einem Photovoltaikmodul bestehend aus zwei äußeren Glasscheiben 20 und 22, wobei die äußere Glasscheibe 22 zugleich eine Abdeckung eines Photovoltaikmoduls 24 bildet. Die innere Abdeckung des Photovoltaikmoduls 24 bildet eine weitere Scheibe 26, wobei zwischen den Scheiben 22 und 26 die Solarzellen 14 angeordnet sind.

Zur elektrischen Kontaktierung ist an dem Photovoltaikmodul 24 bzw. den einzelnen Strings 12 als elektrischer Anschluss ein Flachkabel bzw. Kontaktbändchen 28 vorgesehen. Das Kontaktbändchen 28 ist dabei durch eine Bohrung in der inneren Scheibe 26 in einen Scheibenzwischenraum 30 geführt. Der Scheibenzwischenraum 30 besteht zwischen der inneren Abdeckscheibe 26 des Photovoltaikmoduls 24 und der Scheibe 20, wobei der Abstand durch einen handelsüblichen Abstandshalterrahmen 32 gewährleistet ist. Der Scheibeninnenraum 30 dient dabei der Isolierfunktion und ist, wie üblich bei Isolierverglasungen, gasgefüllt. Das Kontaktbändchen 28 wird dabei aus dem Scheibeninnenraum 30 durch den Abstandshalterrahmen 32 nach außen herausgeführt. Diese Herausführung muss gas- und dampfdicht sein, um eine Dichtigkeit des Scheibeninnenraums 30 zu gewährleisten.

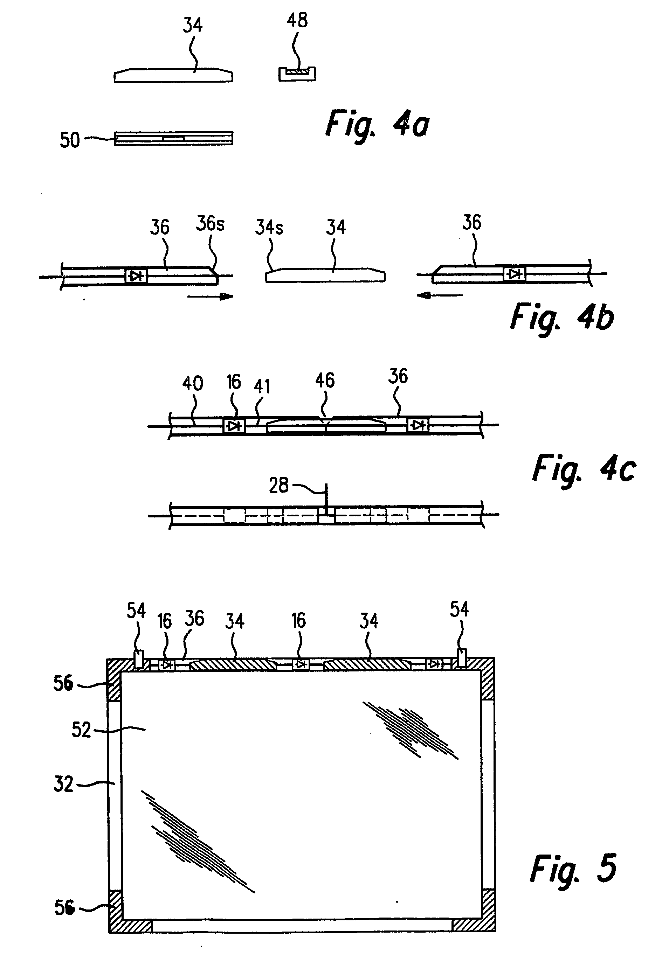

Der Abstandshalterrahmen 32 kann dabei aus Aluminiumhohlprofilelementen bestehen, die durch Verbindungselemente aus Kunststoff, wie sie beispielsweise in Figur 4 gezeigt sind, verbunden werden, indem auf beide Seiten eines Verbindungselementes 34 Randelemente 36 des Abstandshalterrahmens 32 aufgeschoben und dort reibschlüssig gehalten sind.

Figur 2 zeigt nun in der unteren Darstellung b) eine alternative Herausführung des Kontaktbändchens 28, bei der das Kontaktbändchen 28 "von außen" durch den Abstandshalterrahmen 32 in den Scheibeninnenraum 30 oder in den Abstandshalterrahmen 32 hineingeführt wird, wobei hierzu insbesondere vorgesehen sein kann, dass die innere Abdeckung 26 im wesentlichen bündig in der Bilddarstellung links mit dem Abstandshalterrahmen 32 abschließt, so dass bei einer Ausfüllung des verbleibenden Freiraums 38 zwischen der Scheibe 20 und der Scheibe 22 der elektrische Kontakt durch den dort angebrachten Dichtstoff sicher umschlossen wird. Diese Gestaltung besitzt den Vorteil, dass die Abdeckung 26 nicht durchbohrt werden muss. Darüber hinaus kann die Dichtigkeit des Innenraums 30 leichter hergestellt werden.

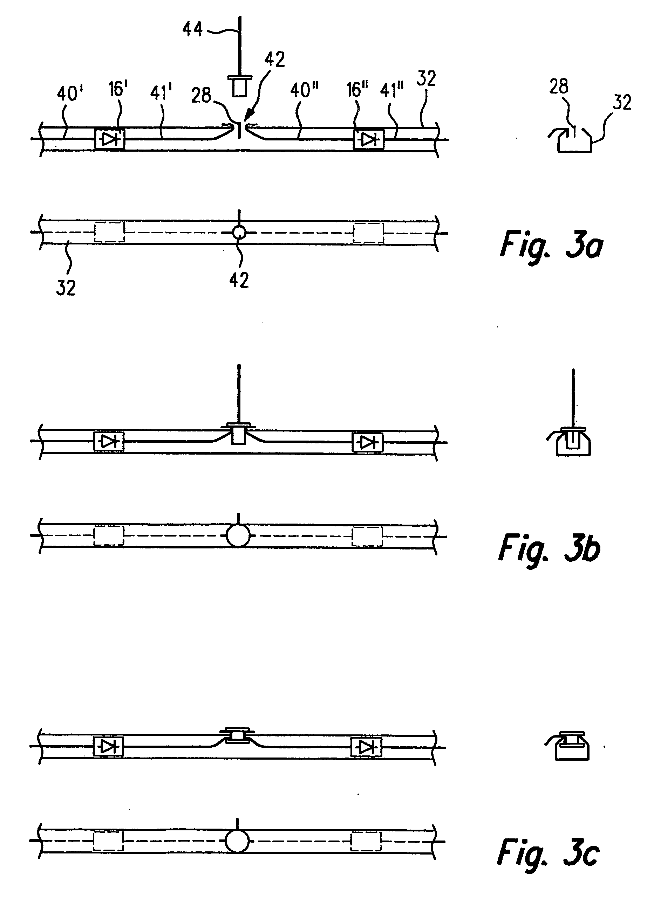

Figur 3 zeigt eine Montage und Kontaktierung der einzelnen Strings 12 mit den Bypassdioden 16, dabei ist von den Strings 12 lediglich eines der Kontaktbändchen 28 dargestellt.

Die linke Darstellung der einzelnen Schritte a) bis c) von Figur 3 zeigt jeweils einen Längsschnitt durch einen entsprechenden Abstandshalterrahmen 32 in der oberen Darstellung und eine Draufsicht in der unteren. In der rechten Darstellung ist jeweils ein Querschnitt durch den Abstandshalterrahmen 32 gezeigt.

Figur 3 zeigt, dass die Dioden 16 erfindungsgemäß im Hohlprofil des Abstandshalterrahmens 32 angeordnet sind. Dabei weisen die Dioden elektrische Anschlusselemente 40 und 41 auf, mit denen sie untereinander in Reihe geschaltet sind. Die Reihenschaltung der Dioden 16 (hier 16' und 16") sowie die Parallelschaltung zu den jeweiligen Strings 12 über die Kontaktbändchen 28 erfolgt über Bohrungen im Rahmen 32.

Dabei werden die elektrischen Anschlusselemente 41' sowie das Anschlusselement 40" der benachbarten Diode durch eine Öffnung 42 im Abstandshalterrahmen 32 herausgeführt, wobei an dieser Stelle bei Verwendung eines Aluminiumhohlprofils eine elektrische Isolierung vorgesehen ist. Zugleich wird an dieser Stelle das Kontaktbändchen 28 in den Abstandshalterrahmen 32 von außen eingeführt. Die Herausführung des Bändchens 28 erfolgt hier gemäß Figur 2b). Es wird dann ein sogenannter "Blindniet" 44 in die Öffnung 42 eingesetzt, wie in der zweiten Darstellung b) von oben gezeigt ist. Der Blindniet 44 wird festgelegt (Darstellung c), wobei darauf zu achten ist, dass eine elektrische Kontaktierung zwischen den Anschlusselementen 41' und 40" sowie dem Kontaktbändchen 28 erfolgt.

Um eine gute Kontaktierung zu erreichen, kann dabei vorgesehen sein, dass der Blindniet selbst elektrisch leitfähig ist, wobei er dann ebenfalls gegenüber dem Abstandshalterrahmen 32 isoliert sein muss. Nach der Montage der verschiedenen elektrischen Kontakte wird der Bereich 38 (Figur 2) dann mit Dichtstoff versiegelt und damit auch elektrisch isoliert.

Die Dioden 16 liegen erfindungsgemäß gegen die Wandung des Abstandshalterrahmens 32 an und leiten die durch ihren Widerstand entstehende Wärme über den Abstandshalterrahmen ab. Hierbei ist es vorteilhaft, wenn der Rahmen eine innere Metallauskleidung aufweist, da hierdurch die Wärmeleitfähigkeit und die Wärmeabführung verbessert wird.

Figur 4 zeigt nun eine alternative Kontaktierungsmöglichkeit. Bei der Alternative gemäß Figur 4 besteht der einzelne Rahmen aus einer Reihe von Randelementen 36 aus einem Hohlprofil sowie Verbindungselementen 34 (Darstellung a)) insbesondere aus einem Kunststoffspritzgussmaterial. Die Randelemente 36 werden dabei auf die Verbindungselemente 34 aufgeschoben (Darstellung b)), wobei sowohl die Randelemente 36 als auch die Verbindungselemente 34 an ihren Rändern Abschrägungen 36s bzw. 34s aufweisen. Die Abschrägung 34s der Verbindungselemente 34 dient dabei zur Erleichterung des Aufschiebens und insbesondere des Einführens der Verbindungselemente 34 in die Randelemente 36. Durch die Abschrägung 36s der Randelemente 36 verbleibt am Ende bei vollständig aufgeschobenen Randelementen 36 (Darstellung c)) zwischen den Randelementen 36 ein Zwischenraum 46, in dem das Verbindungselement 34 nicht durch die Randelemente 36 überdeckt ist.

Darüber hinaus weist das Verbindungselement 34 an der Stelle, die nicht durch die Randelemente 36 überdeckt wird, ein Lötplättchen 48 auf, das nach Aufschieben der Randelemente 36 durch den entsprechenden Spalt von außen frei zugänglich ist.

Die elektrischen Anschlüsse 40 sowie 41 der Bypassdioden 16 werden dabei in einer Nut 50 des elektrischen Anschlusselementes so geführt, dass sie mit dem ebenfalls in der Nut angeordneten Lötplättchen 48 in Überdeckung gelangen bei vollständig aufgeschobenen Randelementen 36 auf das Verbindungselement 34.

Zusätzlich wird das Kontaktbändchen 28 an die Lötstelle, die durch das Lötplättchen 48 gebildet wird, herangeführt und es erfolgt eine Verlötung der elektrischen Anschlusselemente 40 und 41 der jeweiligen Dioden mit dem Kontaktbändchen 28.

Figur 5 zeigt nun eine montierte PV-Isolierglasscheibe im Schnitt durch den Rahmen 32. Dabei besteht der Rahmen 32 aus verschiedenen Abstandshalterprofilen, wobei an drei Seiten durchlaufende Profile verwandt wurden und die Profile an den Ecken über sogenannten "Eckverbinder" 50 miteinander verbunden wurden. Lediglich an einer Seite der Isolierglasscheibe 52, an der die elektrische Kontaktierung erfolgt und die Anschlüsse herausgeführt sind, wurde das Abstandshalterprofil entsprechend der drei vorhandenen Strings (nicht dargestellt) aus mehreren Randelementen 36 aufgebaut, die durch Verbindungselemente 34 verbunden wurden, gemäß Figur 4, wobei in jedem der Randelemente 36 eine von drei Bypassdioden 16 geführt ist. Darüber hinaus ist im Bereich der Eckverbinder 50, an dieser Seite der Scheibe 52 vorgesehen worden, elektrische Kontaktelemente in Form von Buchsen 54 vorzusehen, mit denen ein externer Anschluss des PV-Isolierglasmoduls erfolgen kann.

Nach der fertigen Montage der PV-Isolierglasscheibe kann dann ein elektrischer Anschluss im Rahmen der Scheibenmontage z. B. an einer Fassade über die berührungsgeschützten Buchsen 54 erfolgen, indem an der Fassade bzw. dem Hausdach vorhandene Steckelemente in die Buchsen 54 eingesteckt werden. Auf diese Weise wird ein Transportschutz erreicht und die Länge der externen Anschlusskabel ist bei der Vorortmontage individuell wählbar.

Schließlich zeigt Figur 6 eine alternative Ausgestaltung des Abstandshalterprofils 32, wobei hier das Abstandshalterprofil 32 bereits in seinem in eine Dichtmasse 60 eingebetteten Zustand gezeigt ist. Der Abstandshalterrahmen 32 besteht aus einem Kunststoffprofil 62, in das eine Stromführungsschiene in Form einer Metallfolie 64 eingelegt worden ist. Die Bypassdioden 16 können in diesem Fall unmittelbar mit der Stromführungsschiene 64 zusammenwirken, so dass auf die im Abstandshalterrahmen 32 geführten elektrischen Anschlusselemente 40 und 41 der Bypassdioden 16 verzichtet werden kann.

Insgesamt wird erfindungsgemäß eine Integration der Bypassdioden mit hohem Vorfertigungsgrad der Photovoltaik-Isolierglasscheiben 52 erreicht, bei gleichzeitiger Verwendung einer Vielzahl von Standardteilen, so dass Fehlmontagen letztendlich weitestgehend vermieden werden können.

## Patentansprüche

1. Photovoltaik-Isolierglasscheibe umfassend eine dem einfallenden Licht zugewandten Außenscheibe (22) und eine hierzu beabstandete und mit der Außenscheibe (22) einen Scheibeninnenraum (30) einschließende Innenscheibe (20), wobei im Randbereich der Scheiben zwischen diesen ein aus einem Hohlprofil gebildeter Abstandshalterrahmen (32) vorgesehen ist, und im Scheibeninnenraum (30) dem einfallenden Licht zugewandt ein oder mehrere Photovoltaikmodule (24, 12) angeordnet sind, und wobei Bypassdioden (16) zwischen die Photovoltaikmodule (12) geschaltet sind, bei der die Bypassdioden (16) in dem Abstandshalterrahmen (32) angeordnet und die elektrischen Anschlusskabel (28) der Photovoltaikmodule (24, 12) an dem Abstandshalterrahmen (32) festgelegt sind, wobei der Abstandshalterrahmen (32) mehrere Randelemente (36) sowie die Randelemente (36) verbindende Verbindungselemente (34) umfasst, **dadurch gekennzeichnet, daß** die Bypassdiode (16) in den Randelementen (36) angeordnet ist.

2. Photovoltaik-Isolierglasscheibe nach Anspruch 1, **dadurch gekennzeichnet, dass** die Kontaktierung der Photovoltaikmodule (12) mit den Bypassdioden (16) im Bereich Verbindungselemente (34) durch Verlöten erfolgt.

3. Photovoltaik-Isolierglasscheibe nach Anspruch 1 oder 2, **dadurch gekennzeichnet, dass** im Abstandshalterrahmen (32) Bohrungen (42) vorgesehen sind, in die ein Bolzen oder Niet (44) zur Klemmung und/oder Kontaktierung der Anschlusskabel (28) der Photovoltaikmodule (12) mit denen (40, 41) der Bypassdioden (16) einsetzbar ist.

4. Photovoltaik-Isolierglasscheibe nach einem der vorangehenden Ansprüche 1 bis 3, **dadurch gekennzeichnet, dass** die Abstandshalterrahmen (32) aus einem kunststoffummantelten Metallprofil bestehen.

5. Photovoltaik-Isolierglasscheibe nach einem der vorangehenden Ansprüche 1 bis 3, **dadurch gekennzeichnet, dass** die Abstandshalterrahmen (32) aus einem Kunststoffprofil (62), insbesondere mit eingelegter Stromschiene (64) bestehen.

## Claims

1. Photovoltaic insulating glass panel comprising an outer panel (22) facing towards the incident light and an inner panel (20) spaced from said outer panel and enclosing, together with the outer panel (22), a panel interior space (30), wherein in the edge region of the panels, between them a spacing frame (32) made from a hollow profile is provided, and in the panel interior space (30), one or more photovoltaic modules (24, 12) are arranged facing towards the incident light, and wherein bypass diodes (16) are connected between the photovoltaic modules (12), whereby bypass diodes (16) are arranged in the spacing frame (32) and the electrical connection cables (28) of the photovoltaic modules (24, 12) are attached to the spacing frame (32), wherein the spacing frame (32) comprises a plurality of edge elements (36) and connecting elements (34) connecting the edge elements (36), **characterised in that** the bypass diode (16) is arranged in the edge elements (36).

2. Photovoltaic insulating glass panel according to claim 1, **characterised in that** connection of the photovoltaic modules (12) to the bypass diodes (16) takes place in the region of the connecting elements (34) by soldering.

3. Photovoltaic insulating glass panel according to claim 1 or 2, **characterised in that** bores (42) are provided in the spacing frame (32), in which bores a bolt or a rivet (44) is insertable for clamping and/or connection of the connecting cable (28) of the photovoltaic module (12) to those (40, 41) of the bypass diodes (16).

4. Photovoltaic insulating glass panel according to one of the preceding claims 1 to 3, **characterised in that** the spacing frame (32) comprises a plastics-covered metal profile.

5. Photovoltaic insulating glass panel according to one of the preceding claims 1 to 3, **characterised in that** the spacing frames (32) comprise a plastics profile (62), in particular having an inlaid conductor rail (64).

## Revendications

1. Vitre en verre isolant photovoltaïque comprenant une vitre extérieure (22) tournée vers la lumière incidente et une vitre intérieure (20) espacée de la première et formant avec la vitre extérieure (22) un espace intérieur de vitre (30), un cadre écarteur (32) formé d'un profilé creux étant prévu dans la zone périphérique des vitres, et un ou plusieurs modules photovoltaïques (24, 12) étant disposés dans l'espace intérieur de vitre (30) tourné vers la lumière incidente, et des diodes de dérivation (16) étant branchées entre les modules photovoltaïques (12), sur laquelle les diodes de dérivation (16) sont disposées dans le cadre écarteur (32) et les câbles de raccordement (28) électriques des modules photovoltaïques (24, 12) sont fixés sur le cadre écarteur (32), le cadre écarteur (32) comprenant plusieurs éléments périphériques (36) et les éléments périphériques (36) des éléments de liaison (34) en connexion, **caractérisée en ce que** la diode de dérivation (16) est disposée dans les éléments périphériques (36).

2. Vitre en verre isolant photovoltaïque selon la revendication 1, **caractérisée en ce que** le contact entre les modules photovoltaïques (12) et les diodes de dérivation (16) s'effectue par brasage dans la zone des éléments de liaison (34).

3. Vitre en verre isolant photovoltaïque selon la revendication 1 ou 2, **caractérisée en ce que** dans le cadre écarteur (32) sont prévus des perçages (42) dans lesquels un boulon ou un rivet (44) peut être inséré pour le serrage et/ou pour le contact des câbles de raccordement (28) des modules photovoltaïques (12) avec ceux (40, 41) des diodes de dérivation (16).

4. Vitre en verre isolant photovoltaïque selon l'une quelconque des revendications 1 à 3 précédentes, **caractérisée en ce que** les cadres écarteurs (32) sont à base d'un profilé métallique enveloppé de plastique.

5. Vitre en verre isolant photovoltaïque selon l'une quelconque des revendications 1 à 3 précédentes, **caractérisée en ce que** les cadres écarteurs (32) sont à base d'un profilé plastique (62), en particulier avec un rail de courant (64) inséré.
